# FASCICULE DE BREVET EUROPEEN

(11) **EP 2 814 048 B1**
(45) Date de publication et mention de la délivrance du brevet: **03.10.2018**
(21) Numéro de dépôt: 14168024.9
(22) Date de dépôt: 13.05.2014
(51) Int. Cl.: H01H 13/76, H01H 13/83, H01H 13/85, G06F 3/02, G06F 3/023, G06F 3/038, H01H 13/02, H01H 13/52, G06F 3/0362, H01H 5/02, H01H 19/02, H01H 25/06

(54) **Dispositif de dialogue homme-machine**
Mensch-Maschine Dialogvorrichtung
Human-machine dialogue device

(30) Priorité: 13.06.2013 FR 1355471
(43) Date de publication de la demande: 17.12.2014
(73) Titulaire: Schneider Electric Industries SAS, 92500 Rueil-Malmaison (FR)
(72) Inventeur: Thizon, Patrice, 16600 Ruelle sur Touvre (FR)
(74) Mandataire: Dufresne, Thierry

(56) Documents cités:
- EP-A1- 2 479 646
- DE-A1- 10 218 294
- DE-A1- 19 839 811
- US-A1- 2005 269 196
- US-A1- 2008 068 117

## Description

### Domaine technique de l'invention

La présente invention se rapporte à un dispositif de dialogue homme-machine. L'invention se rapporte plus particulièrement à un dispositif de dialogue homme-machine modulaire dont l'architecture peut s'adapter facilement à l'application commandée. L'invention concerne également un système de dialogue homme-machine intégrant au moins un dispositif de dialogue homme-machine de l'invention.

### Etat de la technique

Pour commander une application, il est connu d'employer différents types de dispositifs de dialogue homme-machine. Ceux-ci peuvent être à interface de commande de type bouton-poussoir, de type bouton tournant et/ou à interface de visualisation.

Les fonctionnements de ces dispositifs sont différents entre eux et leurs architectures diffèrent également.

Les demandes de brevet DE19839811A1, DE10218294A1, US2008/068117A1, US2005/269196A1, EP2479646A1 décrivent des systèmes de dialogue homme-machine.

Le but de l'invention est de proposer un dispositif de dialogue homme-machine ayant une conception modulaire, permettant à un opérateur de choisir aisément la fonction de son dispositif et de la modifier si nécessaire, sans toucher profondément à son architecture et sans avoir à le démonter en totalité.

### Exposé de l'invention

Ce but est atteint par un dispositif de dialogue homme-machine comprenant :
- un boîtier comportant un poste d'accueil présentant :
   - un ensemble universel de dialogue homme-machine, chaque ensemble universel de dialogue homme-machine comprenant au moins un organe de visualisation et au moins un dispositif capteur,
   - un dispositif universel d'actionnement,
- le poste d'accueil étant agencé pour recevoir indifféremment, de manière amovible et interchangeable :
   - un premier organe modulaire présentant une interface de visualisation agencée pour coopérer avec l'organe de visualisation de l'ensemble universel de dialogue homme-machine de façon à envoyer une information de visualisation colorée générée par l'organe de visualisation, ou
   - un deuxième organe modulaire présentant une interface de commande de type bouton-poussoir agencée pour coopérer avec ledit dispositif capteur en vue de générer au moins un signal de commande et un système d'actionnement agencé pour coopérer avec le dispositif universel d'actionnement en vue de conférer une position de repos et une position actionnée à l'interface de commande, ou
   - un troisième organe modulaire présentant une interface de commande de type bouton tournant agencée pour coopérer avec ledit dispositif capteur en vue de générer au moins un signal de commande et comportant un système d'actionnement agencé pour coopérer avec le dispositif universel d'actionnement en vue de conférer plusieurs positions fixes et/ou fugitives à l'interface de commande.

Selon une particularité, le dispositif universel d'actionnement comporte un premier aimant permanent et un deuxième aimant permanent et deux plaques métalliques situées de part et d'autre du premier aimant permanent.

Selon une autre particularité, le système d'actionnement du deuxième organe modulaire à interface de commande de type bouton-poussoir comporte deux aimants permanents, agencés pour coopérer chacun avec le premier aimant permanent et le deuxième aimant permanent du dispositif universel d'actionnement.

Selon une autre particularité, le système d'actionnement du troisième organe modulaire à interface de commande de type bouton tournant comporte au moins un premier aimant permanent agencé pour coopérer par effet magnétique avec le premier aimant permanent ou avec les deux plaques métalliques pour marquer des positions angulaires distinctes fixes ou fugitives.

Selon une autre particularité, le système d'actionnement du troisième organe modulaire à interface de commande de type bouton tournant comporte un deuxième aimant permanent agencé pour coopérer par effet magnétique avec le deuxième aimant permanent pour conférer une fonction rappel en rotation à l'interface de commande.

Selon une autre particularité, le deuxième organe modulaire ou le troisième organe modulaire comporte également une interface de visualisation agencée pour coopérer avec l'organe de visualisation du poste d'accueil.

Selon une autre particularité, l'interface de visualisation comporte une plaque transparente ou translucide colorée coopérant avec l'organe de visualisation pour renvoyer ladite information de visualisation colorée.

Selon une autre particularité, chaque dispositif capteur comporte au moins trois organes capteurs montés suivant un arc de cercle sur une carte électronique de manière à détecter trois positions angulaires distinctes.

Selon une autre particularité, chaque organe capteur comporte un interrupteur à actionnement mécanique.

Selon une autre particularité, l'interface de commande de type bouton tournant et de type bouton-poussoir comporte au moins une patte d'actionnement agencée pour coopérer avec chaque interrupteur à actionnement mécanique pour conférer un état à son organe modulaire.

Selon une autre particularité, la patte d'actionnement est agencée pour coopérer avec un ou plusieurs desdits trois organes capteurs en vue de coder le type d'interface de commande et d'interface de visualisation.

Selon une autre particularité, le premier organe modulaire à interface de visualisation comporte une patte d'actionnement agencée pour coopérer avec un ou plusieurs desdits trois organes capteurs en vue de coder ladite information de visualisation colorée dudit organe modulaire.

Selon une autre particularité, le boîtier comporte des moyens de fixation sur une paroi et ces moyens de fixation comportent deux orifices destinés à recevoir chacun une vis de fixation.

L'invention concerne un système de dialogue homme-machine comportant au moins un dispositif de dialogue homme-machine tel que défini ci-dessus, une unité centrale de commande et un câble reliant ladite unité centrale de commande à l'ensemble universel de dialogue homme-machine, ladite unité centrale de commande étant agencée pour alimenter chaque ensemble universel de dialogue homme-machine et échanger des signaux avec l'ensemble universel de dialogue homme-machine.

Selon une particularité, l'unité centrale de commande comporte un module logiciel d'apprentissage agencé pour exécuter une étape d'apprentissage permettant de déterminer le type d'organe modulaire positionné sur le poste d'accueil.

Selon une autre particularité, le module logiciel d'apprentissage est agencé pour déterminer le type de l'interface de commande et/ou de visualisation du dispositif de dialogue homme-machine en fonction d'un ou plusieurs états pris par le dispositif capteur lors de l'étape d'apprentissage.

Selon une autre particularité, les dispositifs universels de dialogue homme-machine sont connectés à l'unité centrale de commande par une liaison multipoints en employant un bus de communication et d'alimentation.

Selon une autre particularité, les dispositifs universels de dialogue homme-machine sont connectés à l'unité centrale par une liaison point à point.

Selon une autre particularité, chaque organe modulaire comporte une étiquette électronique mémorisant son type d'interface de commande et/ou de visualisation.

Selon une autre particularité, le système comporte une station de lecture des étiquettes électroniques intégrées dans chaque organe modulaire, ladite station de lecture comportant une antenne agencée à l'intérieur du boîtier.

Selon une autre particularité, le système comporte un module de communication sans-fil agencé pour échanger des données avec l'unité centrale de commande via une liaison sans-fil.

Selon une autre particularité, le système comporte plusieurs postes d'accueil identiques agencés de manière contigüe à l'intérieur du boîtier.

### Brève description des figures

D'autres caractéristiques et avantages vont apparaître dans la description détaillée qui suit faite en regard des dessins annexés dans lesquels :
- la figure 1 représente, vu en perspective, un exemple de réalisation d'un système de dialogue homme-machine comportant plusieurs dispositifs de dialogue homme-machine conformes à l'invention,
- la figure 2 représente, vu de dessus, un exemple de réalisation du système de dialogue homme-machine de la figure 1,
- les figures 3A et 3B représentent, vu en coupe, un dispositif de dialogue homme-machine à interface de commande de type bouton tournant, respectivement avant encliquetage et après encliquetage dans son boîtier,
- la figure 4 représente, vu en coupe, un dispositif de dialogue homme-machine à interface de commande de type bouton-poussoir,
- la figure 5 représente, vu en coupe, un dispositif de dialogue homme-machine à interface de visualisation,
- la figure 6 représente, vu de dessus, un poste d'accueil du dispositif de l'invention,
- la figure 7 illustre de manière schématique le principe de fonctionnement d'un dispositif de dialogue homme-machine à interface de commande de type bouton-poussoir,
- la figure 8 illustre de manière schématique le principe de fonctionnement d'un dispositif de dialogue homme-machine à interface de visualisation,
- les figures 9A à 11B illustrent de manière schématique le principe de fonctionnement d'un dispositif de dialogue homme-machine à interface de commande de type bouton tournant à trois positions fixes,
- les figures 12A à 14B illustrent de manière schématique le principe de fonctionnement d'un dispositif de dialogue homme-machine à interface de commande de type bouton tournant à deux positions fixes,
- les figures 15A à 17B illustrent de manière schématique le principe de fonctionnement d'un dispositif de dialogue homme-machine à interface de commande de type bouton tournant à deux positions fixes et une position de rappel,
- les figures 18A à 20B illustrent de manière schématique le principe de fonctionnement d'un dispositif de dialogue homme-machine à interface de commande de type bouton tournant à deux positions fixes et une position de rappel,
- les figures 21A à 23B illustrent de manière schématique le principe de fonctionnement d'un dispositif de dialogue homme-machine à interface de commande de type bouton tournant à une position fixe et une position de rappel,
- les figures 24A à 26B illustrent le principe de codage de la couleur d'un dispositif de dialogue homme-machine à interface de commande de type bouton-poussoir et à interface de visualisation, respectivement pour trois couleurs distinctes,
- les figures 27 à 29 illustrent le principe de codage de la couleur d'un dispositif de dialogue homme-machine à interface de visualisation, respectivement pour trois couleurs distinctes.

### Description détaillée d'au moins un mode de réalisation

De manière connue, un dispositif de dialogue homme-machine comporte principalement :
- un organe fonctionnel réalisant une fonction de commutation et/ou de visualisation,
- une interface de dialogue homme-machine comprenant une interface de commande sur laquelle agit un utilisateur pour réaliser la fonction de commutation et/ou une interface de visualisation renvoyant une information de visualisation réalisée par l'organe fonctionnel de visualisation.

Par organe fonctionnel à fonction de commutation, on entend les éléments qui permettent de remplir la fonction du dispositif de dialogue homme-machine. Cela inclut tout organe capteur, par exemple à actionnement mécanique ou magnétique, à effet capacitif, inductif, optique ou résistif. Par organe fonctionnel à fonction de visualisation, on entend tout organe de visualisation, tel que par exemple une diode électroluminescente ou un système RVB (Rouge Vert Bleu). La diode électroluminescente pourra être colorée ou de couleur blanche, la couleur de l'organe de dialogue homme-machine étant alors réalisée par l'interface de dialogue homme-machine. Le système RVB est piloté en couleur et en intensité par une unité de commande électronique.

Par interface de commande on entend par exemple un bouton d'actionnement de type bouton-poussoir ou bouton tournant à au moins deux positions et par interface de visualisation, on entend par exemple un cabochon ou une plaque, transparent ou translucide, coloré ou non.

Bien entendu, certains dispositifs de dialogue homme-machine comportent à la fois une interface de commande et une interface de visualisation. C'est par exemple le cas des boutons-poussoirs lumineux.

Par ailleurs, un dispositif de dialogue homme-machine à interface de commande doit également comporter un ensemble d'actionnement chargé de marquer les positions fixes ou fugitives de l'interface de commande. Il peut s'agir d'un ensemble d'actionnement à fonctionnement mécanique et/ou magnétique. Si l'interface de commande est un bouton tournant, cet ensemble d'actionnement permet de définir les différentes positions angulaires, fixes ou fugitives, du bouton. Si l'interface de commande est un bouton-poussoir, l'ensemble d'actionnement permet de rappeler le bouton-poussoir en position de repos après un appui.

L'invention consiste notamment à dissocier l'organe fonctionnel de son interface de dialogue homme-machine en proposant une solution permettant à un utilisateur de configurer son dispositif en choisissant l'interface de dialogue homme-machine qu'il souhaite utiliser sans avoir à toucher à l'organe fonctionnel. En employant un ensemble universel de dialogue homme-machine réalisant toutes les fonctions de l'organe fonctionnel (principalement fonctions de commutation et de visualisation), l'utilisateur peut ainsi y adapter une interface de dialogue homme-machine comprenant une interface de commande et/ou une interface de visualisation. Le dispositif de l'invention est expliqué en détail ci-dessous.

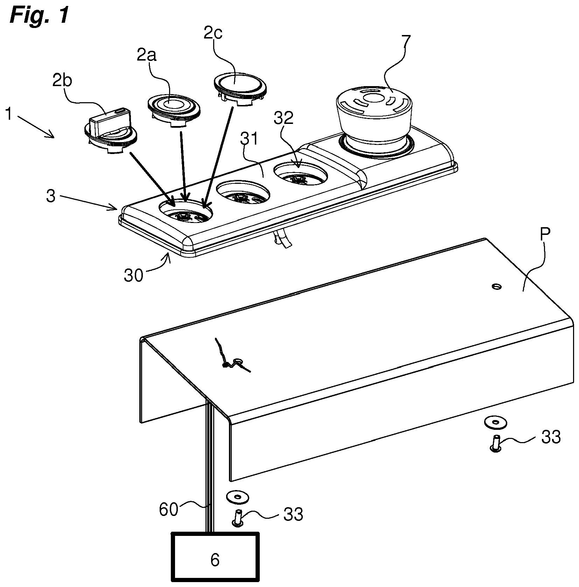

La figure 1 représente un système de dialogue homme-machine comportant plusieurs dispositifs de dialogue homme-machine de l'invention, positionnés de manière adjacente et partageant un même boîtier 3. Dans la suite de la description, le dispositif de dialogue homme-machine de l'invention sera décrit dans le cadre du système représenté sur la figure 1.

En référence à la figure 1, le système 1 comporte ainsi un boîtier 3, par exemple en matière plastique, comprenant une base 30 destinée à être fixée, par sa face inférieure, sur une paroi P, par exemple la paroi d'une armoire électrique ou d'un pupitre de commande, et un capot 31 rapporté sur ladite base 30. Ladite base 30 comporte par exemple des moyens de fixation pour se fixer sur ladite paroi P. Lesdits moyens de fixation comportent par exemple deux orifices (non visibles sur les figures) traversant la base 30 et destinés à recevoir chacun l'extrémité d'une vis 33 traversant la paroi P et la base 30.

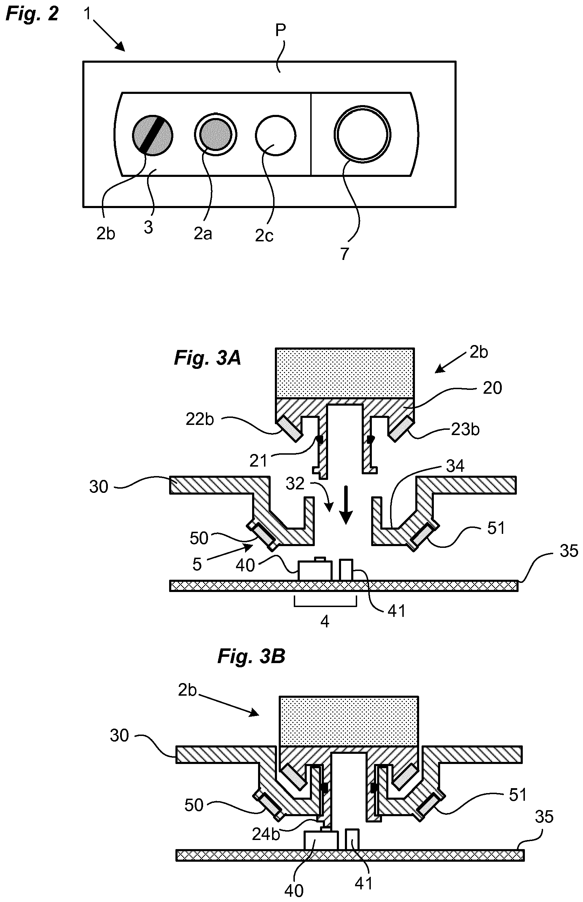

Ledit capot 31 comporte, à travers sa face supérieure, une ou plusieurs ouvertures 32 de taille identique débouchant à l'intérieur du boîtier 3. Ces ouvertures 32 sont préférentiellement de forme circulaire et correspondent ainsi chacune à un poste d'accueil permettant d'accueillir un organe modulaire décrit ci-après. En périphérie de chaque ouverture 32, le capot 31 comporte une cuvette 34 annulaire (voir figure 3A). Chaque ouverture 32 est formée de manière à former une partie tubulaire formant un guide en translation ou en rotation pour une interface de commande.

Tous les postes d'accueil sont identiques de manière à pouvoir accueillir indifféremment différents types d'organes modulaires sans aucune modification.

Chaque poste d'accueil, matérialisé par une ouverture 32 réalisée à travers le capot 31, présente :
- un ensemble universel 4 de dialogue homme-machine,
- un dispositif universel 5 d'actionnement.

L'ensemble universel 4 de dialogue homme-machine est apte à réaliser la fonction de commutation et la fonction de visualisation décrites ci-dessus. Plus précisément, chaque ensemble universel 4 de dialogue homme-machine comporte donc au moins un dispositif capteur 40 chargé de réaliser la fonction de commutation et un organe de visualisation 41 chargé de réaliser la fonction de visualisation. Sur chaque poste d'accueil, toutes les fonctions sont donc réalisées de manière à permettre à un utilisateur de pouvoir y ajouter l'interface de dialogue homme-machine de son choix.

Dans un système tel que représenté sur la figure 1, les ensembles universels 4 de dialogue homme-machine sont par exemple soudés sur une même carte électronique 35 logée à l'intérieur du boîtier 3, un ensemble universel 4 de dialogue homme-machine distinct étant positionné sous chaque ouverture du capot. Sur les figures annexées, une seule carte électronique 35 est employée et celle-ci s'étend à l'intérieur du boîtier.

Plus précisément, un organe de visualisation 41 employé dans un ensemble universel 4 de dialogue homme-machine comporte par exemple une diode électroluminescente ou un système RVB (Rouge Vert Bleu). La diode électroluminescente pourra être colorée ou de couleur blanche, l'interface de visualisation étant transparente, translucide ou colorée. Le système RVB sera par exemple piloté en couleur et en intensité par une unité de commande électronique.

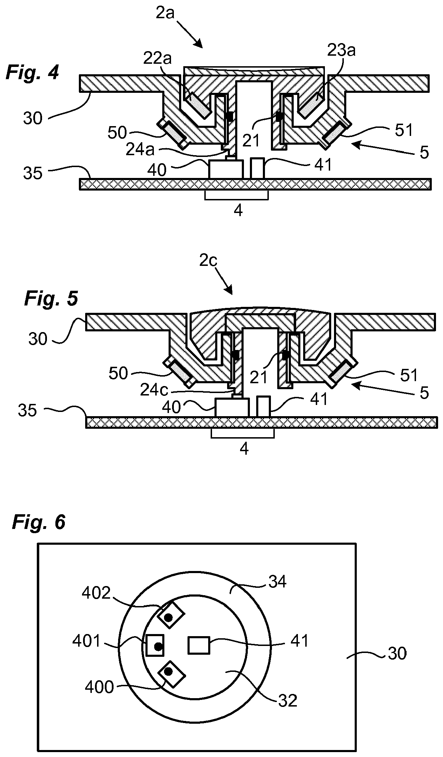

Un dispositif capteur 40 employé dans un ensemble universel 4 de dialogue homme-machine comporte par exemple trois organes capteurs 400, 401, 402 positionnés selon trois positions angulaires distinctes (figure 6). Les trois organes capteurs pourront être des micro-interrupteurs à actionnement magnétique de type "MEMS" ou "reed" ou des micro-interrupteurs à actionnement mécanique. Sur les figures annexées, les trois organes capteurs 400, 401, 402 sont des micro-interrupteurs à actionnement mécanique. Ils sont actionnables directement par l'interface de commande ou par l'interface de visualisation.

Si l'interface de commande est de type bouton tournant, à trois positions fixes ou fugitives, la première position est détectée par le changement d'état d'un seul organe capteur, la deuxième position est détectée par le changement d'état de deux organes capteurs simultanément et la troisième position est détectée par le changement d'état des trois organes capteurs simultanément.

Si l'interface de commande est de type bouton-poussoir, la position de repos est détectée par l'état désactivé (0,0,0) des trois organes capteurs 400, 401, 402 simultanément et la position de travail (enfoncée) est détectée par le changement d'état d'au moins l'un des trois organes capteurs.

Chaque poste d'accueil dispose également d'un dispositif universel d'actionnement 5 identique pouvant s'adapter à un organe modulaire présentant une interface de commande de type bouton tournant ou à un organe modulaire présentant une interface de commande de type bouton-poussoir. Si un poste d'accueil reçoit un organe modulaire doté uniquement d'une interface de visualisation, le dispositif universel d'actionnement associé à ce poste d'accueil ne sera pas employé.

A chaque poste d'accueil, le dispositif universel d'actionnement est agencé pour coopérer avec un système d'actionnement présent dans l'organe modulaire à interface de commande, conférant ainsi à l'organe modulaire son type d'actionnement. Il permet donc de s'adapter à tous types d'interface de commande, en permettant d'assurer la fonction de sélection pour une interface de commande de type bouton tournant, et la fonction de rappel pour une interface de commande de type bouton-poussoir.

Le dispositif universel d'actionnement est préférentiellement de type magnétique, de manière à permettre une indépendance totale par rapport à l'organe modulaire. En référence aux figures annexées, il comporte par exemple deux aimants permanents 50, 51, désignés premier aimant et deuxième aimant, situés de manière diamétralement opposée par rapport à l'ouverture et deux plaques métalliques 52, 53 situées de part et d'autre du premier aimant permanent 50. Les deux aimants permanents 50, 51 et les plaques métalliques 52, 53 sont préférentiellement situés dans des logements réalisés dans le capot, sur la surface interne formée par la cuvette 34. Les deux plaques métalliques 52, 53 et le premier aimant 50 sont agencés pour définir trois positions angulaires distinctes.

Le principe de fonctionnement du dispositif universel d'actionnement sera explicité ci-après.

Selon l'invention, le système 1 de la figure 1 comporte ainsi une pluralité d'organes modulaires 2a, 2b, 2c (désignés 2 de manière générale). Un organe modulaire 2 de l'invention ne comporte ni carte électronique, ni organe fonctionnel de commutation ou de visualisation. Il est indépendant par rapport à son organe fonctionnel. Un organe modulaire à interface de commande comporte pour sa part un système d'actionnement agencé pour coopérer avec un dispositif universel d'actionnement comme décrit ci-dessus.

Selon l'invention, chaque organe modulaire 2 vient occuper un poste d'accueil en se logeant dans une ouverture 32 réalisée à travers le capot 31.

Tous les organes modulaires 2, à interface de commande et/ou à interface de visualisation, présentent une architecture commune. Chaque organe modulaire comporte ainsi un corps 20, par exemple en matière plastique, agencé pour s'enfoncer dans une ouverture 32 du capot et une tête portant l'interface de commande et/ou l'interface de visualisation. Le corps 20 présente une queue de forme tubulaire, ladite queue étant dotée d'une gorge sur sa surface latérale dans laquelle vient se loger un joint à lèvre 21 destiné à assurer l'étanchéité en s'appliquant contre le bord interne de l'ouverture 32. Le corps 20 comporte également une collerette externe destinée à venir se loger dans la cuvette 34 réalisée en périphérie de l'ouverture 32. Selon sa fonction, l'organe modulaire 2 comporte un ou deux aimants logés dans sa collerette.

Selon l'invention, chaque organe modulaire est fixé à travers une ouverture 32 réalisée dans le capot. La fixation est par exemple réalisée par encliquetage du corps 20 de l'organe modulaire 2 sur la profondeur du boîtier au niveau de l'ouverture 32 du poste d'accueil. D'autres moyens de solidarisation peuvent bien entendu être employés.

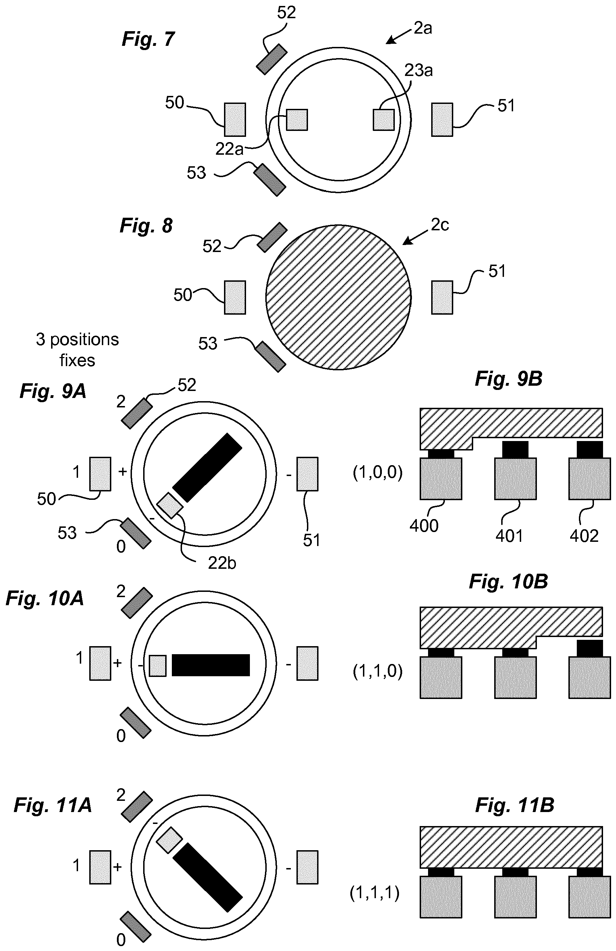

En référence aux figures 4 et 7, un organe modulaire 2a doté d'une interface de commande de type bouton-poussoir comporte deux aimants permanents 22a, 23a, positionnés de manière diamétralement opposée pour se placer en vis-à-vis des deux aimants du dispositif universel d'actionnement. Chacun des deux aimants est orienté de manière à générer un effet magnétique de répulsion avec l'aimant qui lui fait face. Le retour du bouton-poussoir de la position de travail vers la position de repos est donc assuré par l'effet magnétique de répulsion généré entre les aimants 22a, 23a du système d'actionnement et les aimants 50, 51 du dispositif universel d'actionnement. L'interface de commande de type bouton-poussoir comporte plus particulièrement une surface supérieure d'appui, éventuellement transparente ou translucide, colorée ou non, de manière à laisser passer la lumière émise par l'organe de visualisation. Dans le prolongement de sa queue tubulaire, il comporte également une ou plusieurs pattes 24a d'actionnement, agencées pour agir sur un ou plusieurs des organes capteurs 400, 401, 402 de l'ensemble universel 4 de dialogue homme-machine.

En référence aux figures 5 et 8, un organe modulaire 2c doté d'une interface de visualisation comporte plus particulièrement une surface supérieure transparente ou translucide, colorée ou non, de manière à laisser passer la lumière émise par l'organe de visualisation 41 du dispositif universel 4 de dialogue homme-machine. Cet organe modulaire 2c ne présente que la fonction de voyant et ne comporte donc pas de système d'actionnement au sens décrit ci-dessus. Le dispositif universel d'actionnement du poste d'accueil correspondant sera présent mais non employé. De manière avantageuse, l'organe modulaire 2c comporte tout de même une patte d'actionnement 24c dont la fonction sera décrite ci-après.

En référence aux figures 3A et 3B, un organe modulaire 2b doté d'une interface de commande de type bouton tournant comporte plus particulièrement une oreille de préhension lui permettant d'être saisi manuellement. Cette oreille de préhension sera par exemple en matériau opaque, ou en matériau transparent ou translucide, coloré ou non, de manière à laisser passer la lumière émise par l'organe de visualisation 41. Dans le prolongement de sa queue tubulaire, il comporte également une ou plusieurs pattes d'actionnement 24b agencées pour actionner mécaniquement un organe capteur, deux organes capteurs ou trois organes capteurs du dispositif universel 4 de dialogue homme-machine selon la position angulaire sélectionnée. Il comporte également son système d'actionnement destiné à coopérer avec le dispositif universel d'actionnement de son poste d'accueil. Selon son interface de commande, à deux positions fixes, trois positions fixes, une position fixe et une position fugitive ou deux positions fixes et une position fugitive, il comporte un ou deux aimants permanents chargés de coopérer avec le dispositif universel d'actionnement présent à son poste d'accueil.

En référence aux figures 9A à 11B, un organe modulaire 2b doté d'une interface de commande de type bouton tournant à trois positions fixes comporte ainsi un seul aimant 22b permettant au sélecteur de se positionner dans les trois positions définies par le premier aimant permanent 50 et les deux plaques métalliques 52, 53 du dispositif universel 5 d'actionnement. Son aimant 22b est agencé pour faire face au premier aimant 50 du dispositif universel 5 d'actionnement avec une polarité inversée de manière à pouvoir marquer la position. Sur les figures 9A et 9B, le bouton tournant est dans la première position (désignée 0). Un seul organe capteur 400 est activé (état (1,0,0)). Sur les figures 10A et 10B, le bouton tournant est dans la deuxième position (désignée 1). Deux organes capteurs 400, 401 sont activés (état (1,1,0)). Sur les figures 11A et 11B, le bouton tournant est dans la troisième position (désignée 2). Les trois organes capteurs 400, 401, 402 sont activés (état (1,1,1)).

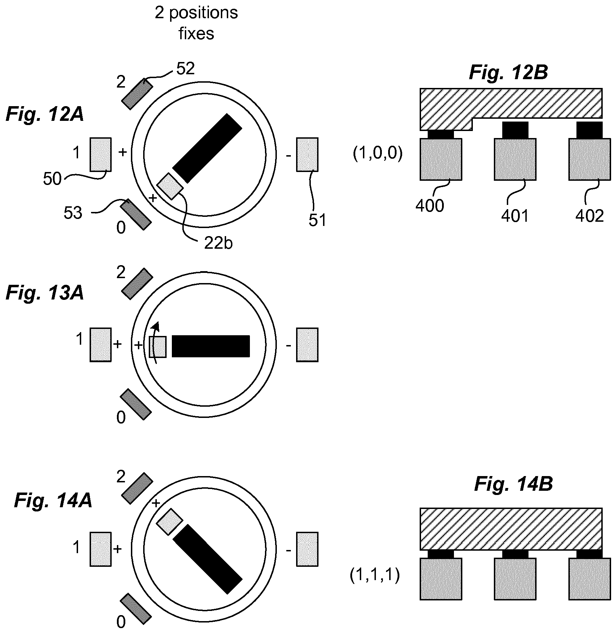

En référence aux figures 12A à 14B, un organe modulaire 2b doté d'une interface de commande de type bouton tournant à deux positions fixes, comporte un aimant permanent 22b. Son aimant permanent 22b est agencé pour faire face au premier aimant 50 du dispositif universel 5 d'actionnement avec une polarité identique de manière à forcer la rotation du sélecteur jusqu'à une position dans laquelle son aimant 22b fait face à l'une ou l'autre des plaques métalliques du dispositif universel d'actionnement. Sur les figures 12A et 12B, le bouton tournant est dans la première position (désignée 0). Un seul organe capteur 400 est activé (état (1,0,0)). Sur la figure 13A, le bouton tournant est entraîné automatiquement (après passage d'un point mort) vers sa deuxième position (désignée 2). Sur les figures 14A et 14B, le bouton tournant est dans sa deuxième position fixe (désignée 2). Les trois organes capteurs 400, 401, 402 sont activés (état (1,1,1)).

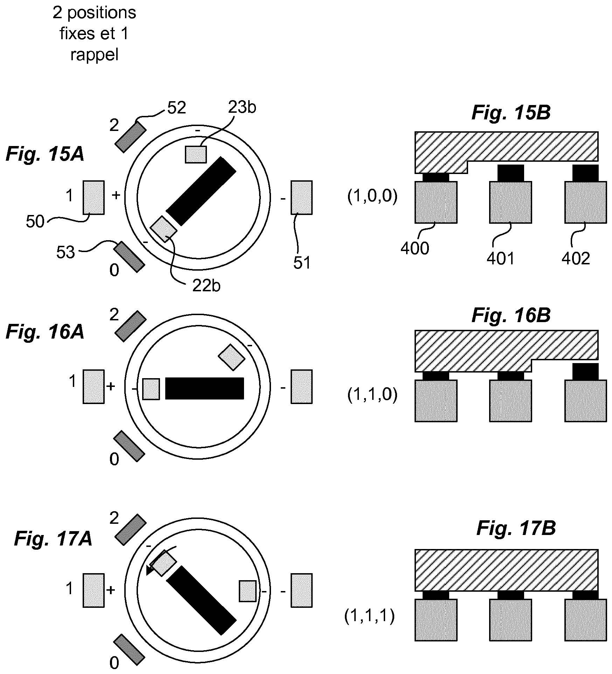

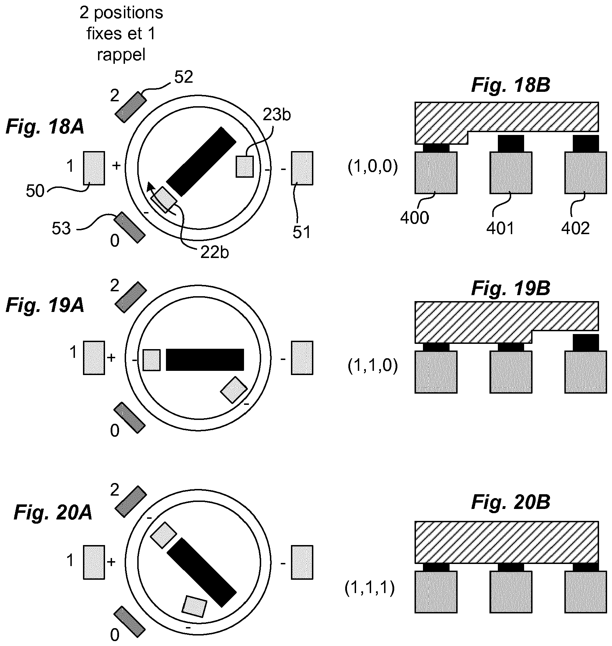

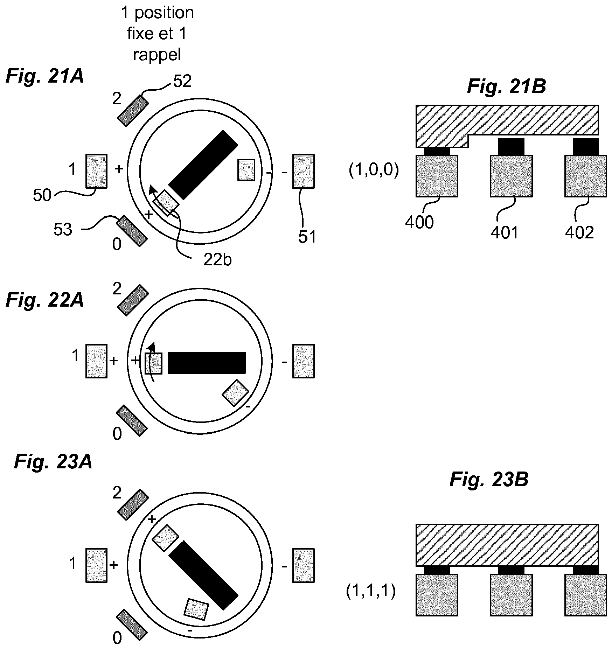

En référence aux figures 15A à 17B, un organe modulaire 2b doté d'une interface de commande de type bouton tournant à deux positions fixes et une position fugitive est réalisé en lui attribuant deux aimants permanents 22b, 23b positionnés dans sa collerette. La première position (désignée 0) est obtenue lorsque son aimant permanent principal 22b est situé en vis-à-vis d'une plaque métallique 53 et sa deuxième position (désignée 1) est obtenue lorsque son aimant permanent principal 22b est situé en vis-à-vis du premier aimant permanent 50. Dans la deuxième position (désignée 1) du sélecteur, l'aimant principal 22b est agencé pour faire face au premier aimant du dispositif universel de dialogue homme-machine avec une polarité inversée de manière à pouvoir marquer la position. Son aimant secondaire 23b est agencé pour faire face au deuxième aimant 51 du dispositif universel 5 d'actionnement avec une polarité identique de manière à générer un effet magnétique de répulsion entre ces deux aimants. Lors d'une rotation vers la troisième position, son aimant secondaire 23b se retrouve en vis-à-vis du deuxième aimant 51 du dispositif universel 5 d'actionnement. L'effet magnétique de répulsion généré entre les deux aimants force le retour du sélecteur vers la deuxième position (désignée 1). Sur les figures 15A et 15B, le bouton tournant est dans la première position (désignée 0). Un seul organe capteur 400 est activé (état (1,0,0)). Sur les figures 16A et 16B, le bouton tournant est dans la deuxième position (désignée 1). Deux organes capteurs 400, 401 sont activés (état (1,1,0)). Sur les figures 17A et 17B, le bouton tournant est dans la troisième position fugitive (désignée 2). Les trois organes capteurs 400, 401, 402 sont activés (état (1,1,1)) temporairement. En relâchant le bouton, celui-ci revient automatiquement dans sa deuxième position. Une variante de réalisation, représentée sur les figures 18A à 20B, consiste à déplacer l'aimant secondaire 23b par rapport à l'aimant principal 22b de manière à rendre la première position fugitive et les deux autres positions fixes. Le principe reste identique. Dans une autre variante de réalisation représentée sur les figures 21A à 23B, en inversant la polarité de l'aimant principal 22b, la deuxième position (désignée 1) n'est plus marquée et le sélecteur devient alors à deux positions, une position fixe (désignée 2) et une position fugitive (désignée 0).

Selon l'invention, les organes modulaires 2 sont positionnés dans le boîtier 3 de manière amovible et interchangeable. Les organes modulaires 2 peuvent être aisément permutés dans le système ou peuvent être chacun remplacés facilement en cas de panne ou en cas d'évolution de la commande.

Selon l'invention, chaque ensemble universel 4 de dialogue homme-machine intégré au support est raccordé à une unité centrale de commande 6 (figure 1) par une liaison point à point ou par une liaison multipoints. L'unité centrale de commande 6 assure l'alimentation et le transfert de données vers chaque ensemble universel 4 de dialogue homme-machine. L'unité centrale de commande pourra être intégrée au système ou réalisée dans un dispositif séparé. L'unité centrale peut donc envoyer un ordre de commande, individuellement, à chaque organe de visualisation 41 d'un ensemble universel 4 de dialogue homme-machine et recevoir un signal de commande de chaque organe capteur 400, 401, 402 des ensembles universels 4 de dialogue homme-machine qui lui sont connectés.

En liaison point à point, chaque ensemble universel 4 de dialogue homme-machine est donc connecté de manière indépendante à l'unité centrale de commande 6. Le boîtier intègre donc une nappe de fils connectée à l'unité centrale de commande 6. Dans cette configuration, un paramétrage de l'unité centrale de commande est nécessaire pour l'informer du type d'organe modulaire placé en vis-à-vis de chaque poste d'accueil.

En liaison multipoints, les ensembles universels 4 de dialogue homme-machine sont connectés à l'unité centrale de commande 6 par l'intermédiaire d'un bus de communication et d'alimentation agencé à l'intérieur du support 3, par exemple sur la carte électronique 31 supportant les ensembles universels 4 de dialogue homme-machine. Un protocole de communication est donc nécessaire pour assurer la communication entre l'unité centrale de commande 6 et les ensembles universels 4 de dialogue homme-machine. En multipoints, chaque signal de commande envoyé par l'unité centrale de commande 6 ou reçu par celle-ci doit comporter l'identifiant de l'ensemble universel 4 de dialogue homme-machine destinataire ou expéditeur. Le protocole de communication est par exemple un protocole à deux fils permettant de faire passer à la fois l'alimentation des dispositifs universels 4 de dialogue homme-machine et les trames de communication échangées entre chaque ensemble universel 4 de dialogue homme-machine et l'unité centrale de commande 6. Un protocole de ce type déjà connu est celui dénommé "OneWire" (appelé également protocole DALLAS) décrit à l'adresse suivante :
http://daniel.menesplier.free.fr/Doc/BUS%201%20WIRE.pdf
Dans une architecture à bus de communication, une étape d'apprentissage sera nécessaire afin d'informer l'unité centrale de commande 6 du type d'organe modulaire 2 présent à chaque poste d'accueil, de manière à ce que l'unité centrale de commande 6 assure une commande adaptée des ensembles universels 4 de dialogue homme-machine.

Selon l'invention, l'unité centrale de commande 6 peut être intégrée au support 3, déportée en partie ou totalement par rapport audit support. Sur la figure 1, l'unité centrale de commande 6 est représentée déportée par rapport au boîtier 3 et reliée aux dispositifs universels 4 de dialogue homme-machine par l'intermédiaire d'un câble 60 assurant l'alimentation et le transfert de données. Sur la figure 1, le câble 60 traverse la paroi P et vient se connecter sur des bornes prévues à l'intérieur du boîtier 3.

De manière avantageuse, le système de dialogue homme-machine sera adapté pour mettre en oeuvre la fonction arrêt d'urgence. Pour cela, le boîtier 3 intègrera un organe capteur apte à réaliser cette fonction, cet organe capteur étant relié à l'unité centrale de commande 6 par une liaison sécurisée. L'organe capteur pourra être associé à un poste d'accueil déterminé, destiné à recevoir un organe spécifique présentant une interface de commande de type arrêt d'urgence 7 (figure 2). En variante de réalisation cet organe spécifique pourra être intégré au boîtier, associé à son organe capteur.

Avantageusement, l'étape d'apprentissage évoquée ci-dessus pourra être réalisée lors du premier actionnement de l'interface de commande d'un organe modulaire 2a, 2b ou de son installation (organe modulaire 2c). Un module logiciel d'apprentissage exécuté dans l'unité centrale de commande 6 permet de détecter s'il s'agit d'une interface de commande de type bouton tournant ou de type bouton-poussoir, ou d'une interface de visualisation seule, par exemple en tenant compte de l'état des organes capteurs de chaque poste d'accueil.

En effet, si l'unité centrale de commande 6 reçoit d'un dispositif capteur 40, successivement, pendant une durée d'apprentissage déterminée, deux états parmi (1,0,0), (1,1,0) et (1,1,1), le module logiciel détermine que l'organe modulaire présent à ce poste d'accueil est à interface de commande de type bouton tournant. Ces états sont par exemple représentés sur les figures 9B, 10B et 11B.

Si l'unité centrale de commande 6 reçoit d'un dispositif capteur 40 l'état (0,0,0) et l'état (1,1,1), le module logiciel détermine que l'organe modulaire présent à ce poste d'accueil est à interface de commande de type bouton poussoir.

Si pendant la durée d'apprentissage déterminée, l'unité centrale de commande 6 ne reçoit qu'un état parmi (1,0,0);(1,1,0);(1,1,1);(0,1,0);(0,1,1);(0,0,1);(1,0,1), elle en déduit que le poste d'accueil est occupé par un organe modulaire 2c à interface de visualisation. Cette particularité permet une configuration en local, sans faire appel à une unité externe de programmation.

Par ailleurs, la couleur de l'interface de visualisation peut également être codée par l'état des organes capteurs. En fonction des organes capteurs activés par la patte d'actionnement 24a, 24c, lors de l'installation et/ou un actionnement de l'organe modulaire, l'unité centrale de commande 6 détermine, par un module logiciel adapté, la couleur de son interface de visualisation. Ceci est valable pour un organe modulaire à interface de visualisation seule ou à interface de commande et interface de visualisation. Il est ainsi possible d'associer une couleur distincte à chacune des combinaisons d'états suivantes : (1,0,0);(1,1,0);(1,1,1);(0,1,0);(0,1,1);(0,0,1);(1,0,1). Selon la combinaison reçue par l'unité centrale de commande 6, pendant la durée d'apprentissage déterminée, le module logiciel détermine la couleur renvoyée par l'interface de visualisation. Ces principes sont détaillés ci-dessous en liaison avec les figures annexées.

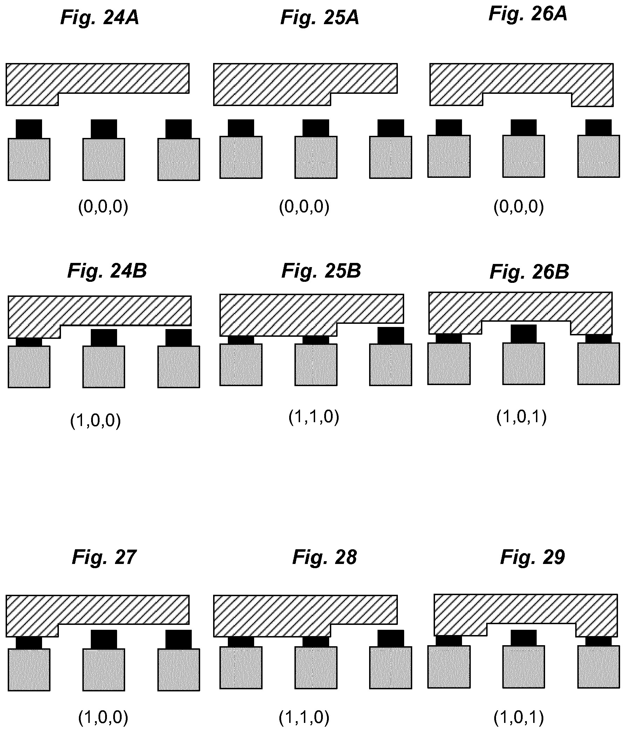

Pour un dispositif de dialogue homme-machine à interface de commande de type bouton-poussoir et à interface de visualisation, son type d'interface est déterminé, lors de l'étape d'apprentissage, par l'état initial (0,0,0) de l'interface de commande (voir ci-dessus). L'actionnement de l'interface de commande entraîne la commutation de un ou deux organes capteurs par la patte d'actionnement 24a et l'unité centrale de commande 6 associe une couleur déterminée à l'état généré ((1,0,0), (1,1,0) ou (1,0,1)). Ceci est illustré sur les figures 24A et 24B pour coder une première couleur, sur les figures 25A et 25B pour coder une deuxième couleur et sur les figures 26A et 26B pour coder une troisième couleur.

Pour un dispositif de dialogue homme-machine présentant uniquement une interface de visualisation, le principe sera le même. L'encliquetage de l'organe modulaire dans l'ouverture 32, entraîne automatiquement l'actionnement de un ou deux des organes capteurs par la patte d'actionnement 24c. L'état (1,0,0), (1,1,0) ou (1,0,1) généré permet à l'unité centrale de commande 6 de déterminer que le dispositif de dialogue homme-machine est à interface de visualisation seule. Chacun de ces états est associé par l'unité centrale de commande 6 à une couleur distincte. Les différents états sont représentés sur les figures 27 à 29.

Avantageusement, chaque organe modulaire 2 peut intégrer une étiquette électronique mémorisant un identifiant et la fonction de l'organe modulaire. Il s'agit par exemple d'une étiquette de type RFID ("Radio Frequency Identification"). Une station de lecture (par exemple intégrée à l'unité centrale de commande 6) comprenant une antenne intégrée au boîtier 3, permet ainsi de détecter les postes d'accueil occupés et de déterminer la fonction de chaque organe modulaire 2 occupant un poste d'accueil. Cette architecture permet ainsi de s'affranchir de l'étape d'apprentissage évoquée ci-dessus ou de la compléter.

Selon une variante de réalisation, le système peut comporter un module de communication sans-fil permettant d'échanger des signaux avec l'unité centrale de commande 6 à travers une liaison sans-fil. La communication pourra être réalisée par exemple par ondes radio via des protocoles connus de type WIFI, Bluetooth... Les données échangées comportent notamment les ordres de commande émis par chaque organe capteur et/ou les ordres d'allumage ou d'extinction émis par l'unité centrale de commande 6 à destination des organes de visualisation. Ce module de communication peut comporter un émetteur/récepteur centralisé, intégré au boîtier 3 et chargé d'échanger des données avec l'unité centrale de commande 6. Il peut également comporter plusieurs émetteurs/récepteurs distincts associés chacun à un dispositif universel 4 de dialogue homme-machine.

L'invention consiste donc à désolidariser les fonctions de commutation et de visualisation, réalisées par le dispositif capteur et par l'organe de visualisation, de l'interface de commande et/ou de visualisation. En proposant d'employer des dispositifs universels de dialogue homme-machine embarquant les deux fonctions, il est ainsi possible de s'affranchir de contraintes de positionnement des organes modulaires, de facilement choisir sa configuration et de la modifier. Par ailleurs, en intégrant un dispositif universel d'actionnement, chaque organe modulaire est encore allégé, ce qui permet d'améliorer sa fiabilité et de diminuer son coût.

Le système 1 de dialogue homme-machine de l'invention présente donc les avantages suivants :
- il permet à un opérateur de choisir ou d'adapter sa configuration, en fonction de l'application commandée,
- il permet de remplacer aisément un organe modulaire par un autre,
- il est facile à installer, en ce qu'il ne nécessite que deux trous de fixation pour le support et un trou pour le passage du câble,
- il permet de proposer des organes modulaires à un coût modéré, ceux-ci n'embarquant aucune carte électronique et comportant une étanchéité standard,
- la carte électronique étant logée à l'intérieur du boîtier, il est aisé d'assurer son isolation par rapport à l'extérieur et de garantir un bon niveau d'étanchéité,
- il est peu encombrant,
- il permet d'employer des organes modulaires embarquant un minimum de pièces mécaniques, engendrant un fonctionnement simple et fiable,
- les fonctions n'étant portées que par des parties mécaniques, les positions des interfaces de commande sont conservées, même en cas de coupure de l'alimentation électrique.

## Revendications

1. Dispositif (1) de dialogue homme-machine, comprenant :
- un boîtier comportant un poste d'accueil présentant :
- un ensemble universel (4) de dialogue homme-machine, chaque ensemble universel (4) de dialogue homme-machine comprenant au moins un organe de visualisation (41) et au moins un dispositif capteur (40),
- un dispositif universel d'actionnement (5),
le dispositif étant **caractérisé en ce que** :
- le poste d'accueil est agencé pour recevoir indifféremment, de manière amovible et interchangeable :
- un premier organe modulaire (2c) présentant une interface de visualisation agencée pour coopérer avec l'organe de visualisation de l'ensemble universel de dialogue homme-machine de façon à envoyer une information de visualisation colorée générée par l'organe de visualisation, ou
- un deuxième organe modulaire (2a) présentant une interface de commande de type bouton-poussoir agencée pour coopérer avec ledit dispositif capteur (40) en vue de générer au moins un signal de commande et un système d'actionnement agencé pour coopérer avec le dispositif universel d'actionnement (5) en vue de conférer une position de repos et une position actionnée à l'interface de commande, ou
- un troisième organe modulaire (2b) présentant une interface de commande de type bouton tournant agencée pour coopérer avec ledit dispositif capteur (40) en vue de générer au moins un signal de commande et comportant un système d'actionnement agencé pour coopérer avec le dispositif universel d'actionnement (5) en vue de conférer plusieurs positions fixes et/ou fugitives à l'interface de commande.

2. Dispositif selon la revendication 1, **caractérisé en ce que** le dispositif universel d'actionnement (5) comporte un premier aimant permanent (50) et un deuxième aimant permanent (51) et deux plaques métalliques (52, 53) situées de part et d'autre du premier aimant permanent.

3. Dispositif selon la revendication 2, **caractérisé en ce que** le système d'actionnement du deuxième organe modulaire à interface de commande de type bouton-poussoir comporte deux aimants permanents (22a, 23a), agencés pour coopérer chacun avec le premier aimant permanent (50) et le deuxième aimant permanent (51) du dispositif universel (5) d'actionnement.

4. Dispositif selon la revendication 2, **caractérisé en ce que** le système d'actionnement du troisième organe modulaire à interface de commande de type bouton tournant comporte au moins un premier aimant permanent (22b) agencé pour coopérer par effet magnétique avec le premier aimant permanent (50) ou avec les deux plaques métalliques (52, 53) pour marquer des positions angulaires distinctes fixes ou fugitives.

5. Dispositif selon la revendication 4, **caractérisé en ce que** le système d'actionnement du troisième organe modulaire à interface de commande de type bouton tournant comporte un deuxième aimant permanent (23b) agencé pour coopérer par effet magnétique avec le deuxième aimant permanent (51) pour conférer une fonction rappel en rotation à l'interface de commande.

6. Dispositif selon la revendication 1, **caractérisé en ce que** le deuxième organe modulaire ou le troisième organe modulaire comporte également une interface de visualisation agencée pour coopérer avec l'organe de visualisation du poste d'accueil.

7. Dispositif selon la revendication 1, **caractérisé en ce que** l'interface de visualisation comporte une plaque transparente ou translucide colorée coopérant avec l'organe de visualisation (41) pour renvoyer ladite information de visualisation colorée.

8. Dispositif selon la revendication 1, **caractérisé en ce que** chaque dispositif capteur comporte au moins trois organes capteurs montés suivant un arc de cercle sur une carte électronique de manière à détecter trois positions angulaires distinctes.

9. Dispositif selon la revendication 8, **caractérisé en ce que** chaque organe capteur (40) comporte un interrupteur à actionnement mécanique.

10. Dispositif selon la revendication 9, **caractérisé en ce que** l'interface de commande de type bouton tournant et l'interface de commande de type bouton-poussoir comportent chacune au moins une patte d'actionnement (24a, 24b) agencée pour coopérer avec chaque interrupteur à actionnement mécanique pour conférer un état à son organe modulaire.

11. Dispositif selon la revendication 10, **caractérisé en ce que** la patte d'actionnement (24a, 24b) est agencée pour coopérer avec un ou plusieurs desdits trois organes capteurs (400, 401, 402) en vue de coder le type d'interface de commande et d'interface de visualisation.

12. Dispositif selon la revendication 8 ou 9, **caractérisé en ce que** le premier organe modulaire à interface de visualisation comporte une patte d'actionnement (24c) agencée pour coopérer avec un ou plusieurs desdits trois organes capteurs en vue de coder ladite information de visualisation colorée dudit organe modulaire.

13. Dispositif selon la revendication 1, **caractérisé en ce que** le boîtier comporte des moyens de fixation sur une paroi (P) et **en ce que** ces moyens de fixation comportent deux orifices destinés à recevoir chacun une vis de fixation (33).

14. Système de dialogue homme-machine, **caractérisé en ce qu'**il comporte au moins un dispositif de dialogue homme-machine tel que défini à l'une des revendications 1 à 13, une unité centrale de commande (6) et un câble (60) reliant ladite unité centrale de commande (6) à l'ensemble universel (4) de dialogue homme-machine, ladite unité centrale de commande (6) étant agencée pour alimenter chaque ensemble universel (4) de dialogue homme-machine et échanger des signaux avec l'ensemble universel (4) de dialogue homme-machine.

15. Système selon la revendication 14, **caractérisé en ce que** l'unité centrale de commande (6) comporte un module logiciel d'apprentissage agencé pour exécuter une étape d'apprentissage permettant de déterminer le type d'organe modulaire positionné sur le poste d'accueil.

16. Système selon la revendication 15, **caractérisé en ce que** le module logiciel d'apprentissage est agencé pour déterminer le type de l'interface de commande et/ou de visualisation du dispositif de dialogue homme-machine en fonction d'un ou plusieurs états pris par le dispositif capteur lors de l'étape d'apprentissage.

17. Système selon la revendication 14, **caractérisé en ce que** les ensembles universels (4) de dialogue homme-machine sont connectés à l'unité centrale de commande (6) par une liaison multipoints en employant un bus de communication et d'alimentation.

18. Système selon la revendication 14, **caractérisé en ce que** les ensembles universels (4) de dialogue homme-machine sont connectés à l'unité centrale par une liaison point à point.

19. Système selon la revendication 14, **caractérisé en ce que** chaque organe modulaire (2) comporte une étiquette électronique mémorisant son type d'interface de commande et/ou de visualisation.

20. Système selon la revendication 19, **caractérisé en ce qu'**il comporte une station de lecture des étiquettes électroniques intégrées dans chaque organe modulaire (2), ladite station de lecture comportant une antenne agencée à l'intérieur du boîtier (3).

21. Système selon la revendication 14, **caractérisé en ce qu'**il comporte un module de communication sans-fil agencé pour échanger des données avec l'unité centrale de commande (6) via une liaison sans-fil.

22. Système selon la revendication 14, **caractérisé en ce qu'**il comporte plusieurs postes d'accueil identiques agencés de manière contigüe à l'intérieur du boîtier.

## Patentansprüche

1. Mensch-Maschine-Dialogvorrichtung (1), welche umfasst:
- ein Gehäuse, das eine Aufnahmestation umfasst, welche aufweist:
- eine universelle Mensch-Maschine-Dialoganordnung (4), wobei jede universelle Mensch-Maschine-Dialoganordnung (4) wenigstens ein Visualisierungsorgan (41) und wenigstens eine Sensorvorrichtung (40) umfasst,
- eine universelle Betätigungsvorrichtung (5),
wobei die Vorrichtung **dadurch gekennzeichnet ist, dass**:
- die Aufnahmestation dafür ausgelegt ist, unterschiedslos, lösbar und austauschbar aufzunehmen:
- ein erstes modulares Organ (2c), das eine Visualisierungsschnittstelle aufweist, die dafür ausgelegt ist, mit dem Visualisierungsorgan der universellen Mensch-Maschine-Dialoganordnung zusammenzuwirken, um eine von dem Visualisierungsorgan erzeugte Information zur farbigen Visualisierung zu senden, oder
- ein zweites modulares Organ (2a), das eine Steuerungsschnittstelle vom Typ eines Drucktasters aufweist, die dafür ausgelegt ist, mit der Sensorvorrichtung (40) zusammenzuwirken, um wenigstens ein Steuerungssignal zu erzeugen, und ein Betätigungssystem, das dafür ausgelegt ist, mit der universellen Betätigungsvorrichtung (5) zusammenzuwirken, um die Steuerungsschnittstelle mit einer Ruheposition und einer betätigten Position auszustatten, oder
- ein drittes modulares Organ (2b), das eine Steuerungsschnittstelle vom Typ eines Drehknopfes aufweist, die dafür ausgelegt ist, mit der Sensorvorrichtung (40) zusammenzuwirken, um wenigstens ein Steuerungssignal zu erzeugen, und ein Betätigungssystem umfasst, das dafür ausgelegt ist, mit der universellen Betätigungsvorrichtung (5) zusammenzuwirken, um die Steuerungsschnittstelle mit mehreren festen und/oder vorübergehenden Positionen auszustatten.

2. Vorrichtung nach Anspruch 1, **dadurch gekennzeichnet, dass** die universelle Betätigungsvorrichtung (5) einen ersten Permanentmagneten (50) und einen zweiten Permanentmagneten (51) und zwei Metallplatten (52, 53), die sich beiderseits des ersten Permanentmagneten befinden, umfasst.

3. Vorrichtung nach Anspruch 2, **dadurch gekennzeichnet, dass** das Betätigungssystem des zweiten modularen Organs mit Steuerungsschnittstelle vom Typ eines Drucktasters zwei Permanentmagneten (22a, 23a) umfasst, die dafür ausgelegt sind, mit dem ersten Permanentmagneten (50) bzw. dem zweiten Permanentmagneten (51) der universellen Betätigungsvorrichtung (5) zusammenzuwirken.

4. Vorrichtung nach Anspruch 2, **dadurch gekennzeichnet, dass** das Betätigungssystem des dritten modularen Organs mit Steuerungsschnittstelle vom Typ eines Drehknopfes wenigstens einen ersten Permanentmagneten (22b) umfasst, der dafür ausgelegt ist, durch Magnetwirkung mit dem ersten Permanentmagneten (50) oder mit den zwei Metallplatten (52, 53) zusammenzuwirken, um unterschiedliche feste oder vorübergehende Winkelpositionen zu markieren.

5. Vorrichtung nach Anspruch 4, **dadurch gekennzeichnet, dass** das Betätigungssystem des dritten modularen Organs mit Steuerungsschnittstelle vom Typ eines Drehknopfes einen zweiten Permanentmagneten (23b) umfasst, der dafür ausgelegt ist, durch Magnetwirkung mit dem zweiten Permanentmagneten (51) zusammenzuwirken, um die Steuerungsschnittstelle mit einer Funktion der Drehrückholung auszustatten.

6. Vorrichtung nach Anspruch 1, **dadurch gekennzeichnet, dass** das zweite modulare Organ oder das dritte modulare Organ ebenfalls eine Visualisierungsschnittstelle aufweist, die dafür ausgelegt ist, mit dem Visualisierungsorgan der Aufnahmestation zusammenzuwirken.

7. Vorrichtung nach Anspruch 1, **dadurch gekennzeichnet, dass** die Visualisierungsschnittstelle eine farbige durchsichtige oder durchscheinende Platte umfasst, die mit dem Visualisierungsorgan (41) zusammenwirkt, um die Information zur farbigen Visualisierung weiterzusenden.

8. Vorrichtung nach Anspruch 1, **dadurch gekennzeichnet, dass** jede Sensorvorrichtung wenigstens drei Sensororgane umfasst, die entlang eines Kreisbogens auf einer elektronischen Karte angebracht sind, um drei verschiedene Winkelpositionen zu detektieren.

9. Vorrichtung nach Anspruch 8, **dadurch gekennzeichnet, dass** jedes Sensororgan (40) einen mechanisch betätigten Schalter umfasst.

10. Vorrichtung nach Anspruch 9, **dadurch gekennzeichnet, dass** die Steuerungsschnittstelle vom Typ eines Drehknopfes und die Steuerungsschnittstelle vom Typ eines Drucktasters jeweils wenigstens eine Betätigungslasche (24a, 24b) umfassen, die dafür ausgelegt ist, mit dem jeweiligen mechanisch betätigten Schalter zusammenzuwirken, um ihr modulares Organ in einen Zustand zu versetzen.

11. Vorrichtung nach Anspruch 10, **dadurch gekennzeichnet, dass** die Betätigungslasche (24a, 24b) dafür ausgelegt ist, mit einem oder mehreren der drei Sensororgane (400, 401, 402) zum Codieren des Typs von Steuerungsschnittstelle und von Visualisierungsschnittstelle zusammenzuwirken.

12. Vorrichtung nach Anspruch 8 oder 9, **dadurch gekennzeichnet, dass** das erste modulare Organ mit Visualisierungsschnittstelle eine Betätigungslasche (24c) umfasst, die dafür ausgelegt ist, mit einem oder mehreren der drei Sensororgane zum Codieren der Information zur farbigen Visualisierung dieses modularen Organs zusammenzuwirken.

13. Vorrichtung nach Anspruch 1, **dadurch gekennzeichnet, dass** das Gehäuse Mittel zur Befestigung an einer Wand (P) umfasst, und dadurch, dass diese Befestigungsmittel zwei Öffnungen aufweisen, die dazu bestimmt sind, jeweils eine Befestigungsschraube (33) aufzunehmen.

14. Mensch-Maschine-Dialogsystem, **dadurch gekennzeichnet, dass** es wenigstens eine Mensch-Maschine-Dialogvorrichtung, wie in einem der Ansprüche 1 bis 13 definiert, eine zentrale Steuerungseinheit (6) und ein Kabel (60), das die zentrale Steuerungseinheit (6) mit der universellen Mensch-Maschine-Dialoganordnung (4) verbindet, umfasst, wobei die zentrale Steuerungseinheit (6) dafür ausgelegt ist, jede universelle Mensch-Maschine-Dialoganordnung (4) zu speisen und Signale mit der universellen Mensch-Maschine-Dialoganordnung (4) auszutauschen.

15. System nach Anspruch 14, **dadurch gekennzeichnet, dass** die zentrale Steuerungseinheit (6) ein Lernsoftwaremodul umfasst, das dafür ausgelegt ist, einen Lernschritt auszuführen, der es ermöglicht, den Typ des auf der Aufnahmestation positionierten modularen Organs zu bestimmen.

16. System nach Anspruch 15, **dadurch gekennzeichnet, dass** das Lernsoftwaremodul dafür ausgelegt ist, den Typ der Steuerungs- und/oder Visualisierungsschnittstelle der Mensch-Maschine-Dialogvorrichtung in Abhängigkeit von einem oder mehreren Zuständen zu bestimmen, die von der Sensorvorrichtung während des Lernschrittes angenommen werden.

17. System nach Anspruch 14, **dadurch gekennzeichnet, dass** die universellen Mensch-Maschine-Dialoganordnungen (4) mit der zentralen Steuerungseinheit (6) durch eine Mehrpunktverbindung unter Verwendung eines Kommunikations- und Stromversorgungsbusses verbunden sind.

18. System nach Anspruch 14, **dadurch gekennzeichnet, dass** die universellen Mensch-Maschine-Dialoganordnungen (4) mit der zentralen Steuerungseinheit durch eine Punkt-zu-Punkt-Verbindung verbunden sind.

19. System nach Anspruch 14, **dadurch gekennzeichnet, dass** jedes modulare Organ (2) ein elektronisches Etikett aufweist, auf dem sein Typ der Steuerungs- und/oder Visualisierungsschnittstelle gespeichert ist.

20. System nach Anspruch 19, **dadurch gekennzeichnet, dass** es eine Station zum Lesen der elektronischen Etiketten, die jeweils in die modularen Organe (2) integriert sind, umfasst, wobei die Lesestation eine Antenne umfasst, die im Inneren des Gehäuses (3) angeordnet ist.

21. System nach Anspruch 14, **dadurch gekennzeichnet, dass** es ein Modul zur drahtlosen Kommunikation umfasst, das dafür ausgelegt ist, mit der zentralen Steuerungseinheit (6) über eine drahtlose Verbindung Daten auszutauschen.

22. System nach Anspruch 14, **dadurch gekennzeichnet, dass** es mehrere identische Aufnahmestationen umfasst, die im Inneren des Gehäuses nebeneinander angeordnet sind.

## Claims

1. Human-machine dialogue device (1), comprising:
- a housing containing a docking station having:
- a universal human-machine dialogue assembly (4), each universal human-machine dialogue assembly (4) comprising at least one display unit (41) and at least one sensor device (40),
- a universal actuation device (5),
the device being **characterized in that**:
- the docking station is arranged to receive, without distinction, removably and interchangeably:
- a first modular unit (2c) having a display interface arranged to cooperate with the display unit of the universal human-machine dialogue assembly so as to send coloured display information generated by the display unit, or
- a second modular unit (2a) having a pushbutton-type control interface arranged to cooperate with said sensor device (40) in order to generate at least one control signal and an actuation system arranged to cooperate with the universal actuation device (5) in order to confer a rest position and an actuated position on the control interface, or
- a third modular unit (2b) having a rotary button-type control interface arranged to cooperate with said sensor device (40) in order to generate at least one control signal and comprising an actuation system arranged to cooperate with the universal actuation device (5) in order to confer a plurality of fixed and/or transient positions on the control interface.

2. Device according to Claim 1, **characterized in that** the universal actuation device (5) comprises a first permanent magnet (50) and a second permanent magnet (51) and two metal plates (52, 53) located on either side of the first permanent magnet.

3. Device according to Claim 2, **characterized in that** the actuation system of the second modular unit with pushbutton-type control interface comprises two permanent magnets (22a, 23a), arranged to each cooperate with the first permanent magnet (50) and the second permanent magnet (51) of the universal actuation device (5).

4. Device according to Claim 2, **characterized in that** the actuation system of the third modular unit with rotary button-type control interface comprises at least one first permanent magnet (22b) arranged to cooperate by magnet effect with the first permanent magnet (50) or with the two metal plates (52, 53) to mark fixed or transient distinct angular positions.

5. Device according to Claim 4, **characterized in that** the actuation system of the third modular unit with rotary button-type control interface comprises a second permanent magnet (23b) arranged to cooperate by magnetic effect with the second permanent magnet (51) to confer a rotational return function on the control interface.

6. Device according to Claim 1, **characterized in that** the second modular unit or the third modular unit also comprises a display interface arranged to cooperate with the display unit of the docking station.

7. Device according to Claim 1, **characterized in that** the display interface comprises a coloured transparent or translucent plate cooperating with the display unit (41) to return said coloured display information.

8. Device according to Claim 1, **characterized in that** each sensor device comprises at least three sensor units mounted in a circular arc on an electronic board so as to detect three distinct angular positions.

9. Device according to Claim 8, **characterized in that** each sensor unit (40) comprises a mechanically actuated switch.

10. Device according to Claim 9, **characterized in that** the rotary button-type control interface and the pushbutton-type control interface each comprise at least one actuation tab (24a, 24b) arranged to cooperate with each mechanically actuated switch to confer a state on its modular unit.

11. Device according to Claim 10, **characterized in that** the actuation tab (24a, 24b) is arranged to cooperate with one or more of said three sensor units (400, 401, 402) in order to code the control interface and display interface type.

12. Device according to Claim 8 or 9, **characterized in that** the first modular unit with display interface comprises an actuation tab (24c) arranged to cooperate with one or more of said three sensor units in order to code said coloured display information of said modular unit.

13. Device according to Claim 1, **characterized in that** the housing comprises fastening means on a wall (P) and **in that** these fastening means comprise two orifices intended to each receive a fastening screw (33).

14. Human-machine dialogue system, **characterized in that** it comprises at least one human-machine dialogue device as defined in one of Claims 1 to 13, a central control unit (6) and a cable (60) linking said central control unit (6) to the universal human-machine dialogue assembly (4), said central control unit (6) being arranged to power each universal human-machine dialogue assembly (4) and exchange signals with the universal human-machine dialogue assembly (4).

15. System according to Claim 14, **characterized in that** the central control unit (6) comprises a learning software module arranged to run a learning step making it possible to determine the modular unit type positioned on the docking station.

16. System according to Claim 15, **characterized in that** the learning software module is arranged to determine the type of the control and/or display interface of the human-machine dialogue device as a function of one or more states assumed by the sensor device in the learning step.

17. System according to Claim 14, **characterized in that** the universal human-machine dialogue assemblies (4) are connected to the central control unit (6) by a multipoint link by employing a communication and power supply bus.

18. System according to Claim 14, **characterized in that** the universal human-machine dialogue assemblies (4) are connected to the central unit by a point-to-point link.

19. System according to Claim 14, **characterized in that** each modular unit (2) comprises an electronic tag storing its control and/or display interface type.

20. System according to Claim 19, **characterized in that** it comprises a station for reading electronic tags incorporated in each modular unit (2), said reading station comprising an antenna arranged inside the housing (3).

21. System according to Claim 14, **characterized in that** it comprises a wireless communication module arranged to exchange data with the central control unit (6) via a wireless link.

22. System according to Claim 14, **characterized in that** it comprises a plurality of identical docking stations arranged contiguously inside the housing.
